# EUROPEAN PATENT APPLICATION

(11) **EP 4 325 188 A2**
(43) Date of publication of application: **21.02.2024**
(21) Application number: 23181591.1
(22) Date of filing: 27.06.2023
(51) Int. Cl.: G01K 7/16, H01L 23/34

(54) **BUILT-IN TEMPERATURE SENSORS**

(30) Priority: 27.07.2022 US 202217874709
(71) Applicant: GlobalFoundries U.S. Inc., Malta, NY 12020 (US)
(72) Inventor: ZHAO, Zhixing, 01109 Dresden (DE); CHEN, Yiching, Santa Clara, CA, 95054 (US); RESTREPO, Oscar D., Malta, NY, 12020 (US)
(74) Representative: Lambacher, Michael

(57) **Abstract**

The present disclosure relates to semiconductor structures and, more particularly, to built-in temperature sensors and methods of manufacture. The structure includes: at least one active gate structure; and a built-in temperature sensor adjacent to and on a same device level as the at least one active gate structure, the built-in temperature sensor further includes force lines and sensing lines.

## Description

### BACKGROUND

The present disclosure relates to semiconductor structures and, more particularly, to built-in temperature sensors and methods of manufacture.

A power amplifier is an electronic device that can increase the power of a signal (a time-varying voltage or current). An RF amplifier amplifies signal in the radio frequency range between 20 kHz and 300 GHz. High frequency RF power amplifiers require the device to be operated at high current density, biased at peak Gm (e.g., above 77GHz) or peak Fmax (e.g., >350GHz). This, in turn, results in high heat generation and, in some instances, over-heating of the device/circuit. For example, the temperature rise of the power amplifier due to heat generated during circuit operations can degrade the power amplifier performance and can even impact circuitry at the proximity of the heat source.

### SUMMARY

In an aspect of the disclosure, a structure comprises: at least one active gate structure; and a built-in temperature sensor adjacent to and on a same device level as the at least one active gate structure, the built-in temperature sensor further comprises force lines and sensing lines.
Additional features of the structure are set forth in dependent claims 2 to 6.

In an aspect of the disclosure, a structure comprises: a plurality of adjacent active gate structures; and a built-in temperature sensor comprising a plurality of floating gate structures within source/drain regions of selected active gate structures of the plurality of active gate structures, and further including force lines and sensing lines.
Additional features of the structure are set forth in dependent claims 8 to 14.

In an aspect of the disclosure, a method comprises: providing a voltage at an input line of a built-in temperature sensor that is adjacent to at least one active gate structure; sensing the voltage at the input line; discharging the voltage at an output line of the built-in temperature sensor; sensing the voltage at the output line; determining a resistance as a difference between the voltage at the input line and the voltage at the output line divided by a current through the built-in temperature sensor; and correlating the resistance to a temperature associated with heat generated by the at least one active gate structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a built-in temperature sensor and respective fabrication processes in accordance with aspects of the present disclosure.
FIG. 2 shows a built-in temperature sensor in accordance with additional aspects of the present disclosure.
FIG. 3 shows a built-in temperature sensor in accordance with additional aspects of the present disclosure.
FIG. 4 shows a built-in temperature sensor in accordance with additional aspects of the present disclosure.
FIG. 5 shows a chart comparing temperature to resistance.
FIG. 6 shows a chart comparing temperature to power.

### DETAILED DESCRIPTION

The present disclosure relates to semiconductor structures and, more particularly, to built-in temperature sensors and methods of manufacture. In embodiments, the built-in temperature sensors may be provided in RF/mmW power amplifiers. The RF/mmW power amplifiers may be provided in bulk semiconductor substrate or fully-depleted semiconductor-on-insulator (FDSOI) technologies, in either planar or finFET configurations. For example, the built-in temperature sensors may be built-in floating gate thermal sensors in FDSOI. Advantageously, the built-in temperature sensors can provide in situ temperature monitoring at low cost, e.g., no additional masks needed, with little to no impact on device design.

In embodiments, the built-in temperature sensors monitor the temperature changes at the device level in order to characterize the heating behavior of a power amplifier. The built-in temperature sensors may be used in conjunction with additional temperature detection circuitry for sensing the temperature during circuit operation. The built-in temperature sensors may be, for example, floating gate structures provided in different configurations and/or different locations within the circuitry as described below. For example, the floating gate structures may be in a serpentine configuration surrounding several active gate structures. Also, the floating gate structures may be placed at source and drain regions for relaxed contacted polysilicon pitch (CPP) devices.

The built-in temperature sensors of the present disclosure can be manufactured in a number of ways using a number of different tools. In general, though, the methodologies and tools are used to form structures with dimensions in the micrometer and nanometer scale. The methodologies, i.e., technologies, employed to manufacture the built-in temperature sensors of the present disclosure have been adopted from integrated circuit (IC) technology. For example, the structures are built on wafers and are realized in films of material patterned by photolithographic processes on the top of a wafer. In particular, the fabrication of the built-in temperature sensors uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material lines as is known in the art.

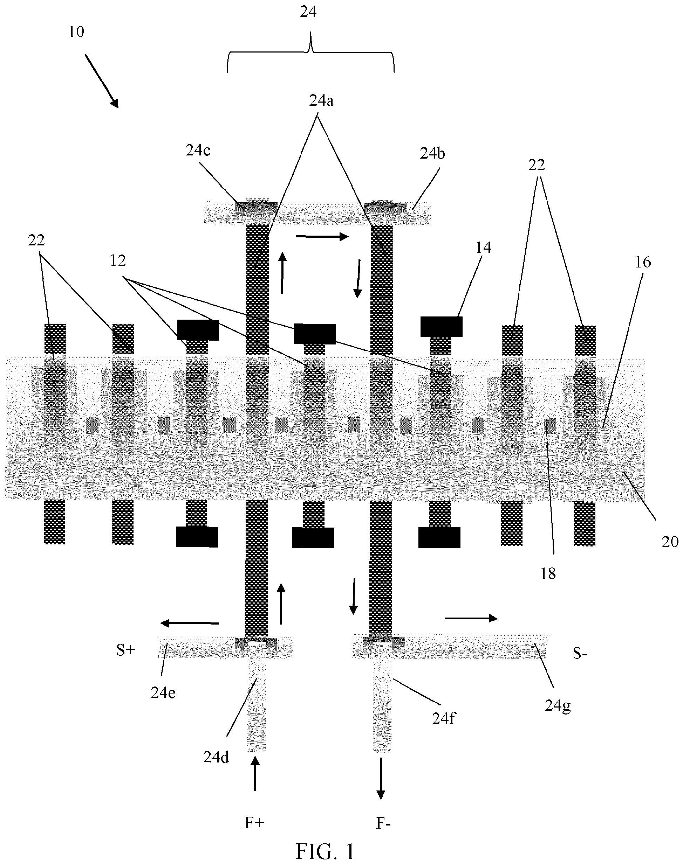

FIG. 1 shows a built-in temperature sensor and respective fabrication processes in accordance with aspects of the present disclosure. More specifically, the structure 10 of FIG. 1 includes a plurality of active gate structures 12 and optional floating gate structures 22 at a same device level. The active gate structures 12 and optional floating gate structures 22 may be planar structures and/or finFET structures using bulk substrate or SOI technologies, and more specifically FDSOI technology. In embodiments, the active gate structures 12 and optional floating gate structures 22 may be polysilicon gate structures, as an example.

The active gate structures 12 and optional floating gate structures 22 include source/drain regions 16. The source/drain regions 16 may be provided by epitaxial semiconductor growth processes with an in-situ doping or ion implantation processes as known to those of skill in the art such that no further explanation is required for a complete understanding of the present disclosure. The active gate structures 12 include gate contacts 14 and the source/drain regions 16 include source/drain contacts 18. The gate contacts 14 and the source/drain contacts 18 may be connected to an upper wiring line depicted at reference numeral 20.

Still referring to FIG. 1, a built-in temperature sensor 24 is provided between or surrounding selected active gate structures 12 at a same device level. In embodiments, the built-in temperature sensor 24 includes a combination of floating gate structures 24a, contacts 24b and upper metal wiring lines 24c-24g. In embodiments, the floating gate structures 24a may be longer than the active gate structures 12 to connect to the upper metal wiring lines 24c-24g without interference by the active gate structures 12. Also, as in each of the different embodiments, the floating gate structures 24a may be parallel to the active gate structures 12. In further embodiments, the floating gate structures 24a may comprise polysilicon material and may be fabricated during the fabrication processes of the active gate structures 12 and optional floating gate structures 22. In addition, the floating gate structures 24a may be formed in the drain/source regions 16.

In embodiments, the built-in temperature sensor 24 includes four terminals, e.g., wiring lines 24d, 24e, 24f, 24g, similar to a Kelvin sensing structure. For example, the wiring lines 24e, 24g may be sensing lines; whereas the wiring lines 24d, 24f may be force lines. In this way, the temperature sensor 24 will be in close proximity to heat generating devices, with two terminals (e.g., wiring lines 24e, 24g) capable of sensing a voltage drop through the built-in temperature sensor 24 and two terminals (wiring lines 24d, 24f) capable of providing and discharging a current through the built-in temperature sensor 24 as described in more detail herein.

In embodiments, the upper metal wiring lines 24c-24g may be on a same device level as the upper wiring line 20. Also, the upper metal wiring lines 20, 24c-24g may be fabricated during the same fabrication processes using conventional lithography, etching and deposition methods. For example, the metal wiring lines 20, 24c-24g and contacts 14, 18 can be fabricated using single damascene processes or a dual damascene process. In either fabrication process, a resist formed over insulator material is exposed to energy (light) and developed to form a pattern (opening) corresponding to the pattern of the metal wiring lines 20, 24c-24g (and contacts 14, 18). An etching process with a selective chemistry, e.g., reactive ion etching (RIE), will be used to transfer the pattern from the resist line to the insulator material. Following the resist removal by a conventional oxygen ashing process or other known stripants, conductive material can be deposited by any conventional deposition processes, e.g., chemical vapor deposition (CVD) processes. Any residual material on the surface of the insulator material can be removed by conventional chemical mechanical polishing (CMP) processes.

Prior to forming the contacts 14, 18, silicide contacts may be formed on active regions of the device, e.g., active gate structures 12 and source/drain regions 16. As should be understood by those of skill in the art, the silicide process begins with deposition of a thin transition metal line, e.g., nickel, cobalt or titanium, over fully formed and patterned semiconductor devices (e.g., doped or ion implanted source and drain regions 16 and respective devices (e.g., active gate structures 12)). After deposition of the material, the structure is heated allowing the transition metal to react with exposed silicon (or other semiconductor material as described herein) in the active regions of the semiconductor device. Following the reaction, any remaining transition metal is removed by chemical etching, leaving silicide contacts in the active regions of the device.

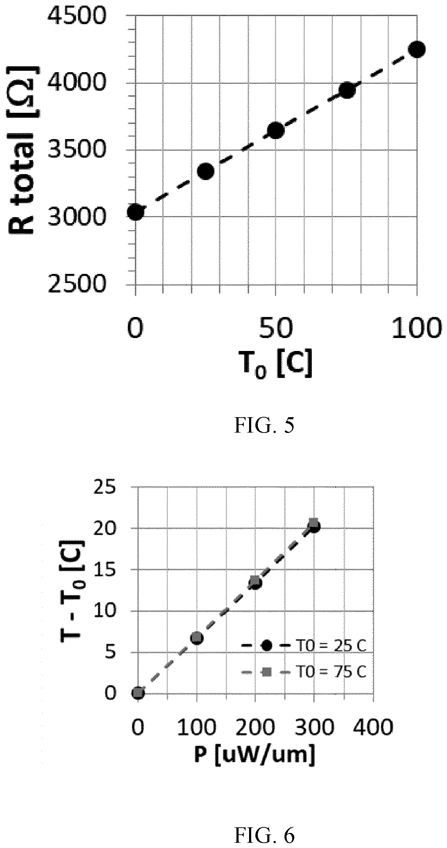

In operation, a voltage and current can be applied to the built-in temperature sensor 24 to measure resistance (R). The resistance (R), in turn, can be used to calculate local temperature (e.g., heat generation) as shown, for example, in FIGS. 5 and 6. For example, the charts shown in FIGS. 5 and 6 show a correlation between resistance and temperature or power and temperature, respectively.

More specifically, a voltage and current may be applied to wiring line 24d as depicted by F+. The current will remain constant throughout the built-in temperature sensor 24. The voltage may be sensed at wiring line 24e as depicted by S+. The current passes through the floating gate structures 24a, contacts 24b, and wiring lines 24c-24g in the direction of the arrows shown in FIG. 1. The current will discharge at wiring line 24f as depicted by F-. The discharge voltage will also be sensed at wiring line 24g as depicted by S-. As should be understood by those of skill in the art, the discharge voltage S- will have dropped compared to the input voltage as sensed at wiring line 24e, e.g., S+.

The temperature of the device can be determined by calculating the resistance, R, e.g., R=V/I, where voltage is a difference between the input voltage S+ and the output voltage S- and current (I) remains constant. And as shown in FIG. 5, for example, temperature increases as the resistance increases.

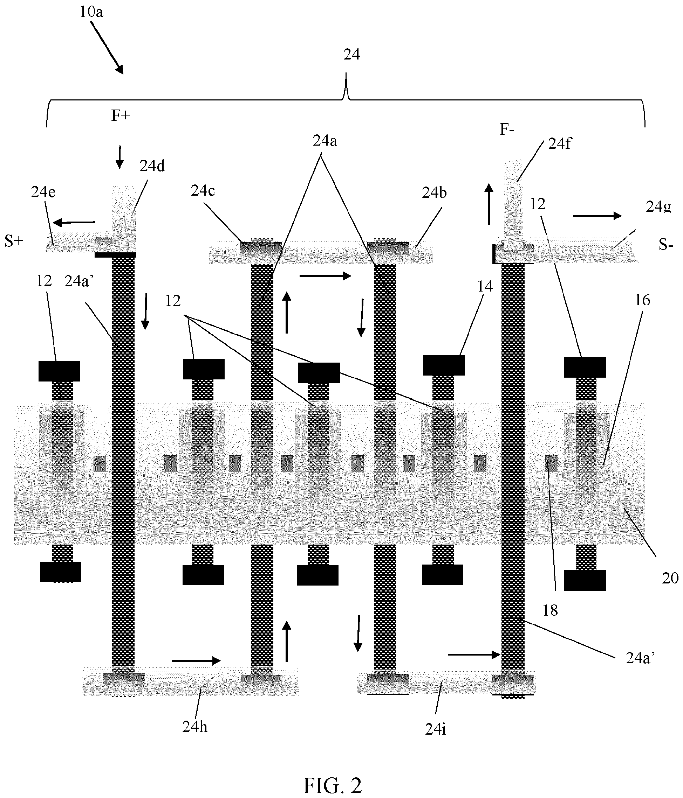

FIG. 2 shows a built-in temperature sensor in accordance with additional aspects of the present disclosure. More specifically, the structure 10a of FIG. 2 includes a built-in temperature sensor 24 in a serpentine configuration. In this configuration, for example, the built-in temperature sensor 24 includes additional floating gate structures 24a' and wiring lines 24h which connect the floating gate structures 24a' to the floating gate structures 24a. In this way, the built-in temperature sensor 24 surrounds multiple active gate structures 12. The current flows in the direction of the arrows, with the two terminals (e.g., wiring lines 24e, 24g) capable of sensing a voltage drop through the built-in temperature sensor 24 and two terminals (e.g., wiring lines 24d, 24f) capable of providing and discharging a current through the built-in temperature sensor 24. The remaining features and operation of the structure 10a are similar to the features and operation of the structure 10 of FIG. 1.

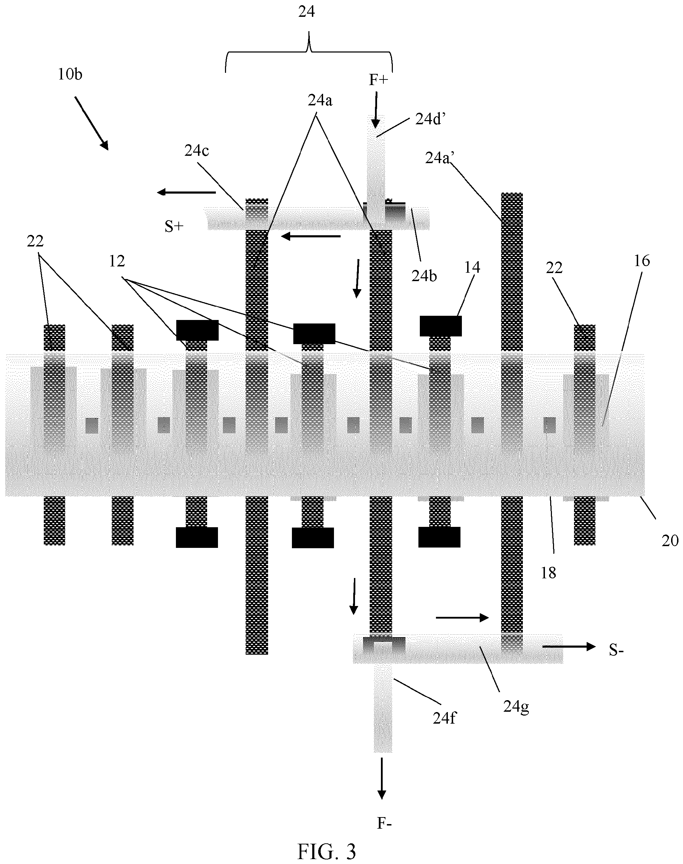

FIG. 3 shows a built-in temperature sensor in accordance with additional aspects of the present disclosure. More specifically, the structure 10b of FIG. 3 includes a built-in temperature sensor 24 in a middle of a device, which surrounds two active gate structures 12. In this configuration, for example, the built-in temperature sensor 24 includes additional floating gate structure 24a' and wiring lines 24c, 24g may connect the floating gate structures 24a, 24a'. Also, the current flows in the direction of the arrows, with two terminals (e.g., wiring lines 24c, 24g) capable of sensing a voltage drop through the built-in temperature sensor 24 and two terminals (wiring lines 24d', 24f) capable of providing and discharging a current through the built-in temperature sensor 24. Also, the two terminals (e.g., wiring lines 24c, 24g) capable of sensing a voltage drop and two terminals (wiring lines 24d', 24f) providing and discharging a current through the built-in temperature sensor 24 extend from a same floating gate structure 24a. The remaining features and operation of the structure 10b are similar to the features and operation of the structure 10 of FIG. 1.

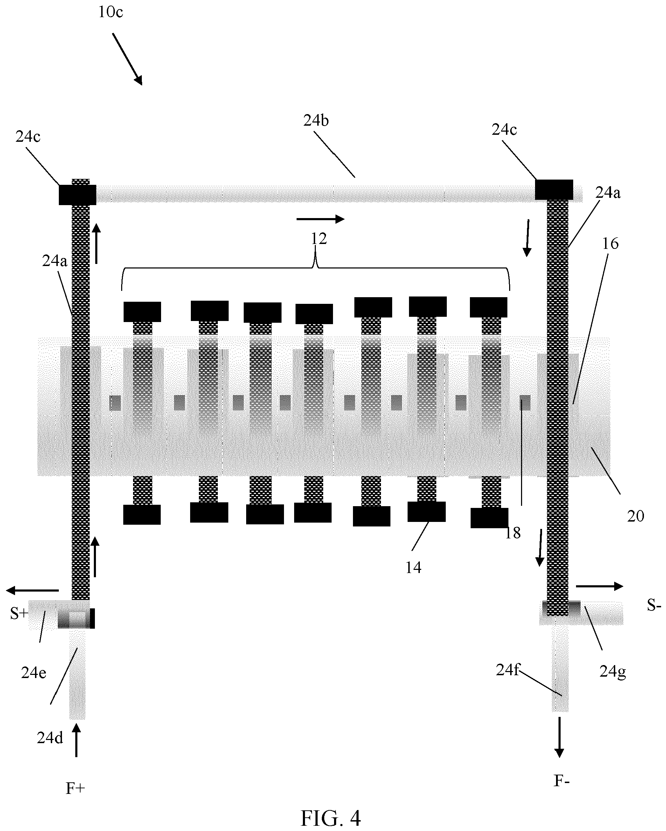

FIG. 4 shows a built-in temperature sensor in accordance with additional aspects of the present disclosure. More specifically, the structure 10c of FIG. 4 includes a built-in temperature sensor 24 spanning across an entire device, which surrounds several active gate structures 12. In this configuration, for example, the built-in temperature sensor 24 includes floating gate structures 24a at two opposing ends of the several active gate structures 12, with the wiring line 24b extending across the several active gate structures 12 to connect the floating gate structures 24a, 24a. As in the previous embodiments, the current flows in the direction of the arrows, with the two terminals (e.g., wiring lines 24e, 24g) capable of sensing a voltage drop through the built-in temperature sensor 24 and two terminals (wiring lines 24d, 24f) capable of providing and discharging a current through the built-in temperature sensor 24. The remaining features and operation of the structure 10c are similar to the features and operation of the structure 10 of FIG. 1.

FIG. 5 shows a graph comparing temperature to resistance. More specifically, in the graph of FIG. 5, temperature is shown on the x-axis and resistance is shown on the y-axis. As seen, temperature increases as resistance increases. As such, it is possible to correlate temperature to resistance and, hence by measuring an increase in voltage, it is possible to calculate resistance correlate the resistance to a temperature of the device.

FIG. 6 shows a graph comparing temperature to power. More specifically, in the graph of FIG. 6, temperature is shown on the y-axis and power is shown on the x-axis. As seen, temperature increases as power increases. As such, it is possible to correlate temperature to power and, hence by measuring voltage, it is possible to correlate the power to a temperature of the device.

The built-in temperature sensors can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
at least one active gate structure; and
a built-in temperature sensor adjacent to and on a same device level as the at least one active gate structure, the built-in temperature sensor further comprising force lines and sensing lines.

2. The structure of claim 1, wherein the built-in temperature sensor comprises floating gate structures which are connect to the force lines and sensing lines.

3. The structure of claim 1 or claim 2, wherein the built-in temperature sensor is parallel to the at least one active gate structure.

4. The structure of one of claims 1 to 3, wherein the built-in temperature sensor comprises two floating gate structures surrounding a single active gate structure, and, optionally, wherein the two floating gate structures are located at source/drain regions of the single active gate structure.

5. The structure of one of claims 1 to 3, wherein the built-in temperature sensor comprises multiple floating gate structures in a serpentine configuration surrounding multiple active gate structures, and optionally, wherein the structure further comprises upper wiring lines connecting the multiple floating gate structures, and the force lines and sensing lines are provided at end floating gate structures of the multiple floating gate structures.

6. The structure of one of claims 1 to 3, wherein the built-in temperature sensor comprises multiple floating gate structures surrounding inner active gate structures, and, optionally, wherein the force lines and the sense lines connect to a single of the multiple floating gate structures.

7. A structure comprising:
a plurality of adjacent active gate structures; and
a built-in temperature sensor comprising a plurality of floating gate structures within source/drain regions of selected active gate structures of the plurality of active gate structures, and further including force lines and sensing lines.

8. The structure of claim 7, wherein at least one of the floating gate structures connect to the force lines and sensing lines.

9. The structure of claim 7 or claim 8, wherein the plurality of floating gate structures are parallel to and surround the plurality of adjacent active gate structures, or wherein the plurality of floating gate structures surround a single active gate structure, or wherein the plurality of floating gate structures are in a serpentine configuration surrounding the plurality of adjacent active gate structures.

10. The structure of one of claims 7 to 9, further comprising wiring lines connecting the plurality of floating gate structures.

11. The structure of one of claims 7 to 10, wherein the plurality of floating gate structures and the plurality of active gate structures are on a same device level.

12. The structure of one of claims 7 to 11, wherein the force lines and the sensing lines extend from a same floating gate structure of the plurality of floating gate structures.

13. The structure of one of claims 7 to 12, wherein the plurality of floating gate structures are provided at opposing ends of the plurality of active gate structures.

14. The structure of one of claims 7 to 13, wherein the built-in temperature sensor comprises multiple floating gate structures surrounding inner active gate structures.

15. A method comprising:
providing a voltage at an input line of a built-in temperature sensor that is adjacent to at least one active gate structure;
sensing the voltage at the input line;
discharging the voltage at an output line of the built-in temperature sensor;
sensing the voltage at the output line;
determining a resistance as a difference between the voltage at the input line and the voltage at the output line divided by a current through the built-in temperature sensor; and
correlating the resistance to a temperature associated with heat generated by the at least one active gate structure.
